# EUROPÄISCHE PATENTSCHRIFT

(11) **EP 2 932 574 B1**
(45) Veröffentlichungstag und Bekanntmachung des Hinweises auf die Patenterteilung: **14.08.2019**
(21) Anmeldenummer: 13795753.6
(22) Anmeldetag: 26.11.2013
(51) Int. Cl.: H02J 7/00, G01R 19/15, H01M 10/42, H01M 10/44, H01M 10/48, B60L 58/18, B60L 58/21, B60L 58/22, G01R 19/165

(54) **VERFAHREN ZUR BATTERIEMODULAUSBALANCIERUNG UND BATTERIEMANAGEMENTSYSTEM**
METHOD FOR BATTERY MODULE BALANCING AND BATTERY MANAGEMENT SYSTEM
PROCÉDÉ D'ÉQUILIBRAGE POUR MODULE DE BATTERIE ET SYSTÈME DE GESTION DE BATTERIE

(30) Priorität: 11.12.2012 DE 102012222746
(43) Veröffentlichungstag der Anmeldung: 21.10.2015
(73) Patentinhaber: Robert Bosch GmbH, 70442 Stuttgart (DE); Samsung SDI Co., Ltd., Gyeonggi-do 446-557 (KR)
(72) Erfinder: FETZER, Joachim, 73342 Bad-Ditzenbach (DE); WOLFF, Hans-Joerg, 73614 Schorndorf (DE); PARTES, Hans, 71679 Asperg (DE); BUTZMANN, Stefan, 71717 Beilstein (DE)
(74) Vertreter: Bee, Joachim
(86) Internationale Anmeldenummer: PCT/EP2013/074668
(87) Internationale Veröffentlichungsnummer: WO 2014/090560

(56) Entgegenhaltungen:
- DE-A1-102010 027 869
- DE-A1-102011 002 548
- US-A- 5 670 861

## Beschreibung

### Stand der Technik

Die vorliegende Erfindung betrifft ein Verfahren zur Batteriemodulausbalancierung und ein Batteriemanagementsystem entsprechend der unabhängigen Ansprüche.

Gegenstand der Erfindung ist auch ein Kraftfahrzeug, das mit einem derartigen Batteriemanagementsystem ausgestattet ist.

Es zeichnet sich ab, dass in Zukunft sowohl bei stationären Anwendungen, z. B. bei Windkraftanlagen, als auch in Fahrzeugen, z. B. in Hybrid- und Elektrofahrzeugen, vermehrt neue Batteriesysteme zum Einsatz kommen werden. Obwohl die Herstellung der Batteriezellen standardisiert verläuft, sind Schwankungen der elektronischen Eigenschaften, beispielsweise der bereitgestellten Spannung, der Batteriekapazität und des inneren komplexen Widerstands beobachtbar. Durch unterschiedlich verlaufende Alterungsprozesse werden die Unterschiede der elektronischen Eigenschaften der Batteriezellen weiter verstärkt.

Die WO 2010/088944 A2 zeigt eine Energiespeicheranordnung mit mehreren in Serie geschalteten Batteriezellen mit einem Leistungsausgang und mit einer Steuereinheit, bei der zumindest ein Teil der in Serie geschalteten Zellen über jeweils parallel geschaltete potentialfrei geregelte Wandler- und Kontrolleinheiten mit dem Leistungsausgang und der Steuereinheit in der Weise verbunden ist, dass mittels gezielter Stromentnahmen durch die Wandler- und Kontrolleinheiten jede der Zellen während der Lade-, Entlade- und Umladevorgänge entsprechend den individuellen Leistungsmerkmalen dieser Zelle betrieben wird. Unterschiedliche Zelltypen werden auf diese Weise zu einer Energiespeicheranordnung zusammengeschaltet, um eine Verlängerung der Gesamtnutzungsdauer zu erzielen.

Die DE 10 2011 002 548 A1 zeigt ein Verfahren zur Steuerung einer Batterie umfassend mindestens einen Batteriemodulstrang mit einer Mehrzahl von in Serie geschalteten Batteriemodulen, wobei jedes der in Serie geschalteten Batteriemodule wenigstens eine Batteriezelle, wenigstens eine Koppeleinheit, einen ersten Anschluss und einen zweiten Anschluss umfasst.

Die US 5 670 861 zeigt einen Überwachungs- und Steuerungsvorrichtung, um den Betrieb elektrischer Funktionen zu steuern, einschließlich der Entladung, während das Fahrzeug fährt, des Ladens, wenn es sich in einer Ladestation befindet, oder des regenerativen Ladens während des Bremsens,

### Offenbarung der Erfindung

### Vorteile der Erfindung

Bei dem erfindungsgemäßen Verfahren zur Batteriemodulausbalancierung mit den Merkmalen des Anspruchs 1 ist vorgesehen, dass ein Batteriemodulzustand zumindest zweier Batteriemodule ermittelt wird und ein Wegschalten einzelner Batteriemodule mit einem niedrigem Batteriemodulzustand erfolgt, wobei der niedrige Batteriemodulzustand
i) durch ein definiertes Verhältnis zu einem Anfangszustand der Batteriemodule oder
ii) durch ein Ergebnis eines Vergleichs aller erfassten Batteriemodulzustände miteinander definiert ist.

Bevorzugt werden die Batteriemodulzustände sämtlicher Batteriemodule erfasst. In dem erfindungsgemäßen Batteriesystem sind die individuellen Batteriezellen nicht wie im Falle herkömmlicher Traktionsbatterien durch eine einfache Reihenschaltung miteinander verbunden. Das erfindungsgemäße Batteriesystem umfasst mindestens einen Batteriemodulstrang, der eine Mehrzahl in Serie oder parallel geschalteter Batteriemodule umfasst, wobei jedes Batteriemodul wiederum eine einzelne oder eine Mehrzahl parallel oder in Serie geschalteter Batteriezellen und eine Koppeleinheit umfasst, welche ausgebildet ist, das Batteriemodul zu- oder wegzuschalten. Um die Batteriemodule zu- oder wegzuschalten werden die Koppeleinheiten von einer zugeordneten Steuereinheit angesteuert.

Ein besonderer Vorteil des erfindungsgemäßen Verfahrens besteht darin, dass eine aktive Ausbalancierung der Batteriemodule durch Priorisierung der Verwendung der einzelnen Batteriemodule erfolgt. Besonders vorteilhaft ist, dass die Überbeanspruchung von schwächeren Batteriemodulen und schwächeren Batteriezellen verhindert wird, was die Lebensdauer der Batterie verlängert. Die installierten Batteriemodule werden somit nachhaltig verwendet. Die Priorisierung erfolgt derart, dass die stärksten und effizientesten Batteriemodule im Betrieb am häufigsten aktiv sind und ermöglicht den schwächsten Batteriemodulen eine Pause, was die vorzeitige Alterung der schwächsten Batteriemodule verhindert. Ohne den Betrieb im Prioritätsmodus würden jederzeit alle Batteriemodule zur Bereitstellung der Energie für den Elektromotor herangezogen werden, mit dem Ergebnis, dass die schwächsten Batteriemodule sich am schnellsten verschlechtern, was ihren baldigen Austausch erzwingen würde.

Durch die in den abhängigen Ansprüchen aufgeführten Maßnahmen sind vorteilhafte Weiterbildungen und Verbesserungen des im unabhängigen Anspruch angegebenen Verfahrens möglich.

Zusätzlich hierzu kann vorgesehen sein, dass die Koppeleinheit ausgebildet ist, die der Koppeleinheit zugeordneten Batteriezellen innerhalb des Batteriemoduls einzeln oder zusammen zu- oder wegzuschalten. Wenn der Steuereinheit Informationen über den Zustand einzelner Batteriezellen bereitstehen, kann diese dazu verwendet werden, nur die schwächsten Batteriezellen eines Batteriemoduls wegzuschalten. Das Zu- und Wegschalten einzelner Batteriezellen ist insbesondere dann möglich, wenn die Anzahl der Zellen in einem Batteriemodul gleich 1 gewählt wird. Innerhalb eines Moduls kann außerdem in bekannter Weise ein Zell-Balancing erfolgen.

Nach einer Ausführungsform ist vorgesehen, eine definierte Anzahl schwächster Batteriemodule wegzuschalten. Die definierte Anzahl kann eine bestimmte Zahl zwischen 1 und der Anzahl von in der Batterie verbauten Batteriemodulen sein. Beispielsweise kann vorgesehen sein, lediglich dasjenige Batteriemodul mit dem niedrigsten Zustand oder die zwei mit dem niedrigsten Zustand oder beispielsweise fünf mit dem niedrigsten Zustand wegzuschalten. Die definierte Anzahl Batteriemodule, die maximal weggeschaltet werden können, kann für jeden Batteriemodulstrang einzeln festgelegt sein.

Nach einer Ausführungsform werden Batteriemodule weggeschaltet, die zur Bereitstellung einer benötigten Ausgangsspannung nicht benötigt werden. Die Anzahl zur Bereitstellung der Ausgangsspannung benötigten Batteriemodule kann sich beispielsweise aus einer Fahrpedalstellung ergeben oder beispielsweise von einem weiteren Steuersystem vorgegeben werden.

Nach einer bevorzugten Ausführungsform werden im Fall ii) alle erfassten Batteriemodulzustände miteinander verglichen und geordnet, d. h. nach einem Kriterium angeordnet. Auf diese Weise sind die Priorisierung und Ausbalancierung über die gesamte Anzahl von Batteriemodulen und Batteriemodulsträngen möglich.

Nach einer Ausführungsform ist im Fall i) ein Schwellwert vorgesehen und als niedriger Batteriemodulzustand gilt ein Batteriemodulzustand unterhalb des Schwellwerts. Der Schwellwert definiert also den niedrigsten zulässigen Batteriezustand und es werden diejenigen Batteriemodule weggeschaltet, deren Wert unterhalb des Schwellwerts liegen. Der Schwellwert wird bevorzugt als ein Prozentsatz in Bezug auf einen Ausgangswert des Batteriemoduls definiert, beispielsweise als ein bestimmter Wert zwischen 1% und 50%, bevorzugt zwischen 10 und 20%, beispielsweise 1%, 5%, 10% oder 20%.

Es kann vorgesehen sein, in jedem Batteriemodulstrang eine bestimmte Anzahl wegschaltbarer Batteriemodule maximal zuzulassen und die Batteriemodule lediglich dann wegzuschalten, wenn ihr Zustand unterhalb des definierten Schwellwerts liegt und wenn die maximale Anzahl noch nicht erreicht wurde.

Nach der Erfindung wird der Schwellwert nach einer bestimmten Zeit und/oder nach einer bestimmten Anzahl von Lade-/Entladezyklen herabgesetzt. Vorteilhaft werden die zu Beginn schwächeren Batteriemodule somit zu späteren Zeitpunkten wieder eingesetzt, wenn ihr ehemals niedriger Wert den nun noch niedrigeren Schwellwert überstiegen hat. Der Schwellwert kann beispielsweise nach jedem fünften oder jedem zehnten Lade- und Entladezyklus um einen bestimmten Prozentwert, beispielsweise um 1%, 2%, 5% oder 10% herabgesetzt werden. Ebenso kann vorgesehen sein, den Schwellwert nach einer bestimmten Anzahl von Tagen, etwa 30 Tage, 60 Tage, 90 Tage oder nach einer bestimmten Anzahl von Betriebsstunden, beispielsweise 10 Stunden, 20 Stunden, 50 Stunden, um einen bestimmten Prozentwert herabzusetzen, beispielsweise um 1%, 2%, 5% oder 10%.

Nach einer Ausführungsform der Erfindung ist der Batteriezustand ein SOC (state of Charge) der Batterie. Der SOC wird bekanntermaßen durch das Batteriemanagementsystem des Fahrzeugs gemessen. Der SOC wird beispielsweise als Funktion der Ruhespannung, d. h. der Zell- bzw. Batterieruhespannung ermittelt und/oder aus einer Stromintegration und/oder aus einer Kombination verschiedener Zustandsgrößen, wie beispielsweise dem letzten ermittelten SOC, der Zell- bzw. Batterietemperatur, der Zell- bzw. Batterieruhespannung und der Stärke des Zell- bzw. Batteriestroms.

Nach einer weiteren Ausführungsform ist der Batteriezustand ein SOH (state of health), welcher eine Funktion zweier oder mehrerer Parameter ausgewählt aus der folgenden Liste ist: Widerstand, Kapazität, SOC, Zeit, Lade-/Entladezyklen und Temperatur. Der SOH wird auch als Gesundheitszustand der Batterie bezeichnet. Das Ende der Batteriezelle ist typischerweise dann erreicht, wenn die Kapazität um 20% des Nominalwerts reduziert ist. Das Lebensende des Batteriemoduls kann aber beispielsweise auch durch den inneren Widerstand der Batterie definiert werden. Wenn der innere Widerstand auf einen bestimmten Wert steigt, beispielsweise auf den zweifachen, dreifachen oder vierfachen Wert des Ausgangswerts, kann auf ein baldiges Ende der Lebensdauer der Batterie geschlossen werden. Es ist schwierig, das Ende der Lebensdauer der Batterie alleine durch den inneren Widerstandswert der Batterie zu bestimmen, da dieser im Allgemeinen ein komplexer Wert ist. Der SOH wird daher im Allgemeinen als ein komplexer Parameter definiert, welcher eine Vielzahl von Informationen umfasst, da er durch verschiedene Parameter bestimmt wird, welche die Lebensdauer der Batteriezelle bzw. des Batteriemoduls bestimmen.

Nach einem weiteren Aspekt der Erfindung wird ein Batteriemanagementsystem für eine Batterie vorgeschlagen, die wenigstens einen Batteriemodulstrang aufweist, der eine Mehrzahl in Serie oder parallel geschalteter Batteriemodule umfasst, wobei jedes Batteriemodul wiederum eine einzelne oder eine Mehrzahl parallel oder in Serie geschalteter Batteriezellen und eine Koppeleinheit umfasst, welche ausgebildet ist, das Batteriemodul zu- oder wegzuschalten, mit einer Batteriemodulzustandserfassungseinheit, die ausgebildet ist, einen Batteriemodulzustand zu erfassen und mit einer Steuereinheit, die an die Batteriemodulzustandserfassungseinheit und an mindestens eine Koppeleinheit gekoppelt ist, und die eingerichtet ist, aufgrund eines ermittelten Batteriemodulzustands ein Steuersignal an die mindestens eine Koppeleinheit zu übermitteln, um die zugeordneten Batteriemodule zu- und wegzuschalten und wobei das Batteriemanagementsystem eingerichtet ist das erfindungsgemäße Verfahren durchzuführen.

Ein weiterer Erfindungsaspekt betrifft ein Kraftfahrzeug mit einem elektrischen Antriebsmotor zum Antreiben des Kraftfahrzeugs und einer mit dem elektrischen Antriebsmotor verbundenen Batterie, die ein derartiges Batteriemanagementsystem aufweist.

### Kurze Beschreibung der Zeichnungen

Ausführungsbeispiele der Erfindung werden anhand der Zeichnungen und der nachfolgenden Beschreibung näher erläutert, wobei gleiche Bezugszeichen gleiche oder funktional gleichartige Komponenten bezeichnen. Es zeigen
- Fig. 1: ein Batteriesystem,
- Fig. 2: ein elektrisches Antriebssystem,
- Fig. 3: eine erste Ausführungsform der Batterie,
- Fig. 4: eine zweite Ausführungsform der Batterie,
- Fig. 5: ein Antriebssystem mit einer Ausführungsform der Batterie,
- Fig. 6: eine schematische Darstellung einer ersten Ausführungsform des erfindungsgemäßen Verfahrens zur Batteriemodulausbalancierung,
- Fig. 7: eine schematische Darstellung einer zweiten Ausführungsform des erfindungsgemäßen Verfahrens zur Batteriemodulausbalancierung,
- Fig. 8: eine schematische Darstellung einer dritten Ausführungsform der erfindungsgemäßen Batteriemodulausbalancierung und
- Fig. 9: eine schematische Darstellung einer vierten Ausführungsform des erfindungsgemäßen Verfahrens zur Batteriemodulausbalancierung.

### Ausführungsformen der Erfindung

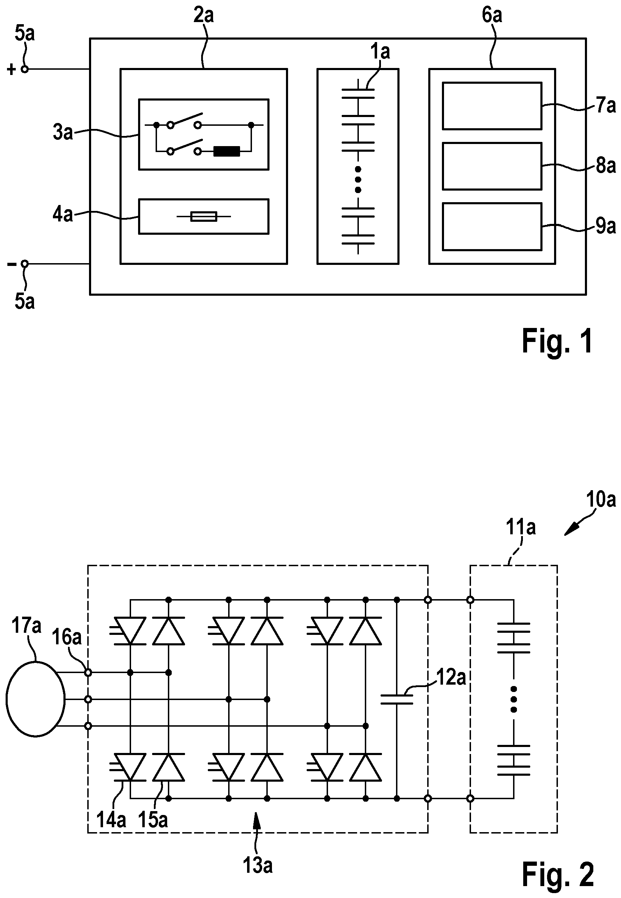

Die Begriffe "Batterie" und "Batteriesystem" werden in der vorliegenden Beschreibung dem üblichen Sprachgebrauch angepasst für Akkumulator bzw. Akkumulatorsystem verwendet. Der prinzipielle funktionelle Aufbau eines Batteriesystems ist in Figur 1 dargestellt. Um die geforderten Leistungs- und Energiedaten mit dem Batteriesystem zu erzielen, werden in einer Batterie einzelne Batteriezellen 1a in Serie und teilweise zusätzlich parallel geschaltet. Zwischen den Batteriezellen 1a und den Polen 5a des Batteriesystems befindet sich eine Safety- und Fuse-Einheit 2a, welche z. B. eine Zu- und Abschalteinheit 3a der Batterie an externe Systeme und die Sicherung 4a des Batteriesystems gegen unzulässig hohe Ströme und Spannungen aufweist. Die Safety- und Fuse-Einheit 2a stellt Sicherheitsfunktionen bereit, wie z. B. das allpolige oder einpolige Abtrennen der Batteriezellen 1a von den Batteriesystempolen 5a bei Öffnen des Batteriesystemgehäuses. Eine weitere Funktionseinheit bildet das Batteriemanagement 6a, welches neben der Batteriezustandserkennung 7a über eine Kommunikationsschnittstelle 8a die Kommunikation mit anderen Systemen und Steuergeräten durchführt sowie das Thermomanagement 9a der Batterie.

Die in Figur 1 dargestellte Funktionseinheit der Batteriezustandserkennung 7a hat die Aufgabe, den aktuellen Zustand der Batterie zu bestimmen sowie das künftige Verhalten der Batterie vorherzusagen, z. B. eine Lebensdauervorhersage und/oder eine Reichweitenvorhersage. Die Vorhersage des künftigen Verhaltens wird auch als Prädiktion bezeichnet. In einer Reihenschaltung der Batteriezellen 1a, wie dargestellt, wird die Leistungsfähigkeit der Batterie durch die elektronischen und chemischen Eigenschaften der schwächsten Zelle bestimmt, die daher im Einsatz am meisten darunter leiden wird. Als Konsequenz der Schwankungen der elektronischen und chemischen Eigenschaften der einzelnen Batteriezellen 1a resultiert eine Schwankung der elektrischen Eigenschaften der Batterie.

Figur 2 zeigt ein schematisches Schaltbild eines üblichen elektrischen Antriebssystems 10a, wie es beispielsweise in Elektro- und Hybridfahrzeugen oder auch in stationären Anwendungen wie bei der Rotorblattverstellung von Windkraftanlagen zum Einsatz kommt. Eine Batterie 11a ist an einen Gleichspannungszwischenkreis angeschlossen, welcher durch einen Kondensator 12a gepuffert wird. An den Gleichspannungszwischenkreis angeschlossen ist ein Pulswechselrichter 13a, der über jeweils zwei schaltbare Halbleiterventile 14a und zwei Dioden 15a an drei Ausgängen 16a gegeneinander phasenversetzte Sinusspannungen für den Betrieb eines elektrischen Antriebsmotors 17a bereitstellt. Die Kapazität des Kondensators 12a ist dabei groß genug gewählt, um die Spannung im Gleichspannungszwischenkreis für eine Zeitdauer zu stabilisieren, in der eines der schaltbaren Halbleiterventile 14a durchgeschaltet wird. In einer praktischen Anwendung wie in einem Elektrofahrzeug ergibt sich eine hohe Kapazität im Bereich von mF.

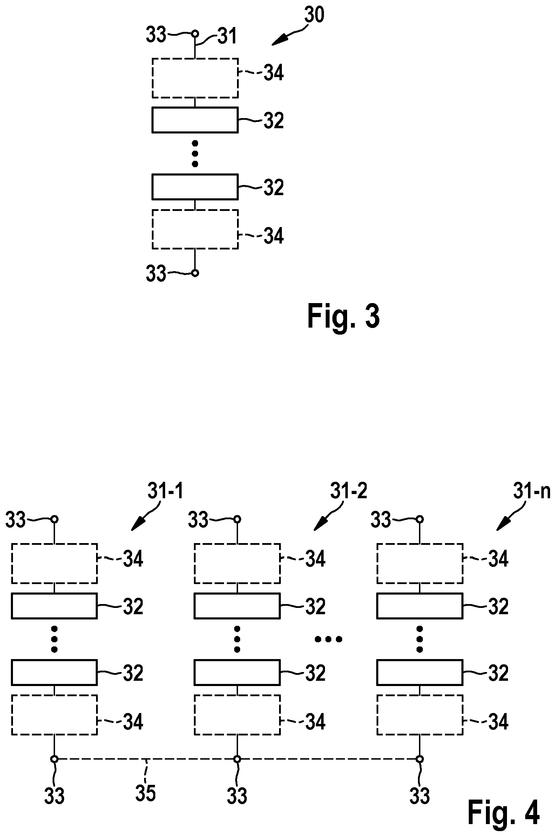

Figur 3 zeigt eine erste Ausführungsform einer Batterie 30 in Form eines Batteriedirektkonverters (BDC, Batterie Direct Converter), welcher über einen Batteriemodulstrang 31 verfügt. Der Batteriemodulstrang 31 weist eine Mehrzahl von Batteriemodulen 32 auf. An den Polen 33 des Batteriemodulstrangs 31 können zusätzlich Lade- und Trenneinrichtungen 34 vorgesehen sein, beispielsweise für den Fall, dass Sicherheitsbestimmungen dies erfordern. Allerdings sind solche Trenneinrichtungen 34 nicht zwingend notwendig, weil eine Abkopplung der Batteriemodule 32 durch in den Batteriemodulen 32 enthaltene hier nicht dargestellte Koppeleinheiten erfolgen kann. Durch die Fahrkontrolleinheit und den Antriebsstrang wird die Batterie 30 angesteuert. Es besteht für das einzelne Batteriemodul 32 die Möglichkeit, in den Batteriemodulstrang 31 entweder zu- oder weggeschaltet zu sein.

Figur 4 zeigt eine zweite Ausführungsform einer Batterie 20 in Form eines Batteriedirektinverters (BDI, Battery Direct Inverter), welche über n Batteriemodulstränge 31-1 bis 31-n verfügt. Jeder Batteriemodulstrang 31-1 bis 31-n weist eine Mehrzahl von Batteriemodulen 32 auf, wobei vorzugsweise jeder Batteriemodulstrang 31-1 bis 31-n dieselbe Anzahl von Batteriemodulen 32 und jedes Batteriemodul 32 dieselbe Anzahl von Batteriezellen in identischer Weise verschaltet enthält. Ein Pol 33 eines jeden Batteriemodulstrangs 31-1 bis 31-n kann mit einem entsprechenden Pol 33 der anderen Batteriemodulstränge 31-1 bis 31-n verbunden sein, was durch eine gestrichelte Linie 35 angedeutet ist. An den Polen 33 der Batteriemodulstränge 31-1 bis 31-n können Lade- und Trenneinrichtungen 34 vorgesehen sein, wenn Sicherheitsbestimmungen dies erfordern. Im Betrieb als Batteriedirektinverter können nahezu sinusförmige Spannungsprofile mit Phasenverschiebung zueinander erzeugt werden, woraus der elektrische Motor mit dem benötigten Drehmoment gespeist werden kann. Die Spannung ist bevorzugt derart, dass der erzeugte Wechselstrom das nötige Drehmoment zum Betrieb des Elektromotors bereitstellt.

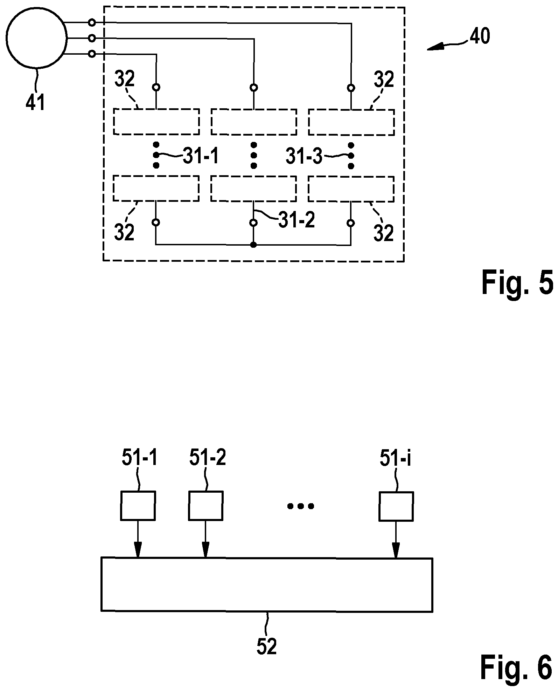

Figur 5 zeigt ein Antriebssystem 40, das eine Ausführungsform der Batterie aufweist. Im dargestellten Beispiel weist die Batterie drei Batteriemodulstränge 31-1, 31-2 und 31-3 auf, welche jeweils direkt an einen Eingang eines Antriebsmotors 41 angeschlossen sind. Da die meisten verfügbaren Elektromotoren auf einen Betrieb mit Dreiphasensignalen ausgelegt sind, besitzt die Batterie genau drei Batteriemodulstränge. Die Batterie besitzt den Vorzug, dass die Funktionalität eines Pulswechselrichters bereits integriert ist. Indem eine Steuereinheit der Batterie eine variable Anzahl von Batteriemodulen 32 in den Batteriemodulsträngen 31-1, 31-2 oder 31-3 aktiviert oder deaktiviert, steht am Ausgang des Batteriemodulstrangs 31-1, 31-2 oder 31-3 eine zu der Anzahl der aktivierten Batteriemodule 32 proportionale Spannung zur Verfügung, welche zwischen 0 V und der vollen Ausgangsspannung der Batteriemodulstränge 31-1, 31-2, 31-3 liegen kann.

Figur 6 zeigt eine schematische Darstellung des erfindungsgemäßen Verfahrens nach einer ersten Ausführungsform. Das Batteriemanagementsystem bestimmt in einem ersten Schritt die SOC-Werte 51-1, 51-2 bis 51-i, von Batteriemodulen 32-1, 32-2 bis 32-i, wobei i die Anzahl der Batteriemodule in der Batterie ist. Die SOC-Werte 51-1, 51-2 bis 51-i der Batteriemodule 32-1, 32-2 bis 32-i werden in einem zweiten Schritt in aufsteigender Reihenfolge gemäß ihrem Absolutbetrag in einem Datenfeld 52 angeordnet. Die Möglichkeit, die Batteriemodule auszuschalten, wird erfindungsgemäß dahingehend genutzt, die schwächsten Batteriemodule inaktiv zu schalten, wodurch die Lebenszeit der Batteriemodule erhöht wird. Wenn beispielsweise das Batteriemodul 32-2 als dasjenige Batteriemodul mit dem niedrigsten SOC-Wert 51-2 bestimmt wurde, gibt die Steuereinheit ein Signal an die entsprechende Koppeleinheit und schaltet das Batteriemodul 32-2 ab. Die Anzahl der abzuschaltenden Batteriemodule, kann von der vom Antrieb benötigten Spannung abhängen. Auf diese Weise kann eine Überbenutzung, d. h. eine Überstrapazierung der schwächsten Batteriemodule verhindert werden. Das Verfahren wird bevorzugt periodisch, nach einer definierten Anzahl von Betriebsstunden, oder von Tagen wiederholt. Die zuvor schwächeren Batteriemodule werden zu einem späteren Zeitpunkt wieder benutzt, da der SOC der anderen Batteriemodule im Betrieb abnimmt. Die schwächeren Batteriemodule können also zu einem späteren Zeitpunkt mit anderen stärkeren Batteriemodulen wiederverwendet, d. h. wieder zugeschaltet werden.

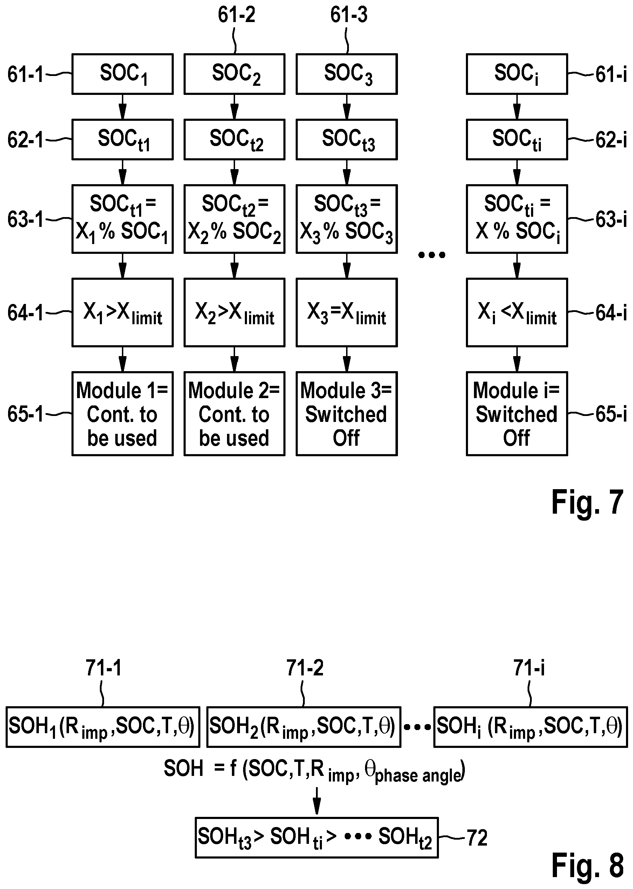

In Figur 7 ist eine weitere Möglichkeit dargestellt, das erfindungsgemäße Verfahren zur Batteriemodulausbalancierung umzusetzen. Auch hier werden einzelne Batteriemodule mit niedrigem Zustand weggeschaltet, wobei ein niedriger Zustand im Verhältnis zu einem Anfangszustand der Batteriemodule definiert ist. Hierzu wird ein Anfangswert 61-1, 61-2 bis 61-i des SOC der einzelnen Batteriemodule 32-1, 32-2 bis 32-i bestimmt, wobei i die Anzahl der Batteriemodule in der Batterie ist. Zu einem definierten Zeitpunkt t wird der Zeitwert 62-1, 62-2 bis 62-i des SOC-Werts der einzelnen Batteriemodule 32-1, 32-2 bis 32-i bestimmt. Ein Berechnungsmodul der Steuereinheit berechnet für jedes Modul das Verhältnis 63-1, 63-2 bis 63-i des Anfangswerts 61-1, 61-2 bis 61-i zum Zeitwert 62-1, 62-2 bis 62-i des SOC. In einem weiteren Schritt wird das Verhältnis 63-1, 63-2 bis 63-i des Anfangswerts 61-1, 61-2 bis 61-i zum Zeitwert 62-1, 62-2 bis 62-i des SOC mit einem Schwellwert verglichen und ein Vergleichsergebnis 64-1, 64-2 bis 64-i erstellt. In einem weiteren Schritt wird für jedes der einzelnen Batteriemodule 32-1, 32-2 bis 32-i eine Entscheidung 65-1, 65-2 bis 65-i getroffen, ob es abgeschaltet wird oder nicht. Das Steuersystem wird hierbei diejenigen Batteriemodule 32-1, 32-2 bis 32-i ausschalten, welche am stärksten vom Schwellwert des SOC abweichen. Im dargestellten Beispiel kann es sein, dass das erste Batteriemodul 63-1 weiterverwendet wird, da das Verhältnis 63-1 größer als der Schwellwert ist, wohingegen das zweite Batteriemodul 63-2 abgeschaltet wird, da das Verhältnis 63-2 niedriger als der Schwellwert ist. Das Steuersystem wird nach einer bestimmten Anzahl von Fahrzyklen einen unterschiedlichen Wert für den Schwellwert ansetzen, wodurch die zuvor schwächeren Batteriemodule zu einem späteren Zeitpunkt benutzt werden können. Die schwächeren Batteriemodule können also zu einem späteren Zeitpunkt mit anderen stärkeren Batteriemodulen wiederverwendet, d. h. wieder zugeschaltet werden.

Figur 8 zeigt eine weitere Ausführungsform des erfindungsgemäßen Verfahrens zur Batteriemodulausbalancierung, wobei zunächst die SOH-Werte 71-1, 71-2 bis 71-i der Batteriemodule 32-1, 32-2 bis 32-i bestimmt werden. Der Index i bezeichnet wiederum die Anzahl der Batteriemodule in der Batterie. Für die Berechnung des SOH stehen verschiedene bekannte Möglichkeiten zur Verfügung. Der SOH kann eine Funktion des SOC, der Temperatur, des reellen Teils der komplexen Impedanz Rᵢₘₚ und/oder der Winkel- bzw. Phaseninformation der komplexen Impedanz sein. In einem weiteren Schritt werden die SOH-Werte zu einem festen Zeitpunkt t der Größe nach in einem dafür vorgesehenen Datenfeld 72 angeordnet. Im dargestellten Beispiel wird festgestellt, dass das Batteriemodul 32-2 den niedrigsten Wert des SOH aufweist, woraufhin es ausgeschaltet wird.

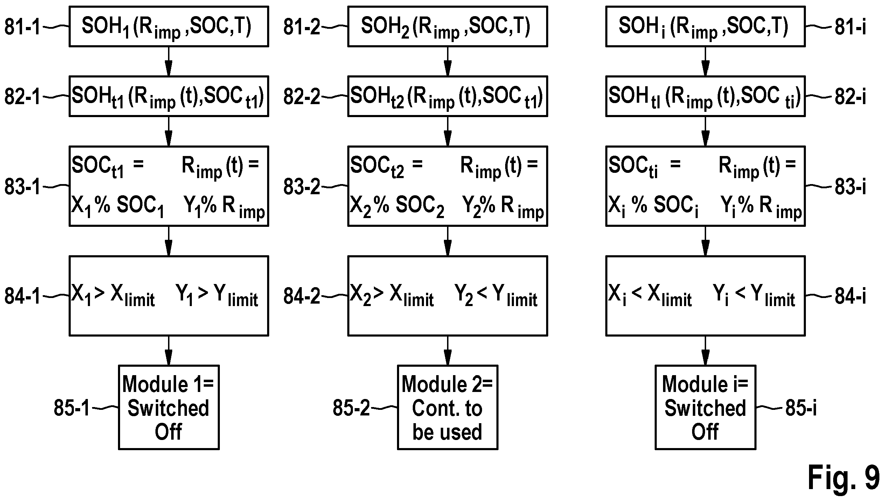

Figur 9 zeigt eine weitere Möglichkeit der Umsetzung des erfindungsgemäßen Verfahrens, bei welchem in einem ersten Schritt der Anfangswert 81-1, 81-2 bis 81-i der SOH-Werte der Batteriemodule 32-1, 32-2 bis 32-i bestimmt wird, zu einem Zeitpunkt t der Zeitwert 82-1, 82-2 bis 82-i der SOH-Werte der Batteriemodule 32-1, 32-2 bis 32-i bestimmt wird und für jedes Batteriemodul 32-1, 32-2 bis 32-i ein Verhältnis 83-1, 83-2 bis 83-i der Anfangswerte 81-1, 81-2 bis 81-i zu den Zeitwerten 82-1, 82-2 bis 82-i des SOH bestimmt wird, wobei i wiederum die Anzahl der Batteriemodule in der Batterie ist. In einem weiteren Schritt werden die Verhältnisse 83-1, 83-2 bis 83-i der Anfangswerte zu den Zeitwerten des SOH mit Schwellwerten verglichen und ein Vergleichsergebnis 84-1, 84-2 bis 84-i erstellt. In einem weiteren Schritt wird für jedes der einzelnen Batteriemodule 32-1, 32-2 bis 32-i eine Entscheidung 85-1, 85-2 bis 85-i getroffen, ob es abgeschaltet wird oder nicht. Das Steuersystem wird hierbei diejenigen Batteriemodule 32-1, 32-2 bis 32-i ausschalten, welche am stärksten vom Schwellwert des SOH abweichen. Wenn beispielsweise der gemessene SOH eines bestimmten Batteriemoduls so ist, dass das Verhältnis des SOC-Wertes viel höher als ein Schwellwert des SOC-Werts ist, dass jedoch das Batteriemodul eine höhere Impedanz aufweist, wird das Steuersystem das Batteriemodul wegschaltet, welches eine höhere Impedanz bzw. einen höheren inneren Widerstand aufweist. Nach einer bestimmten Anzahl von Fahrzyklen und/oder nach einer bestimmten Zeit werden die Grenzwerte des SOH, beispielsweise des SOC und der Impedanz herabgesetzt, wodurch Batteriemodule, welche zunächst schwächer waren, wieder eingesetzt werden können.

## Patentansprüche

1. Verfahren zur Batteriemodulausbalancierung einer Batterie (30), die mindestens einen Batteriemodulstrang (31) aufweist, wobei der mindestens eine Batteriemodulstrang (31) eine Mehrzahl in Serie oder parallel geschalteter Batteriemodule (32) umfasst, wobei jedes Batteriemodul (32) eine einzelne oder eine Mehrzahl parallel oder in Serie geschalteter Batteriezellen und eine Koppeleinheit umfasst, welche ausgebildet ist, das Batteriemodul (32) zu- und wegzuschalten, mit den Schritten:
a) Ermitteln eines Batteriemodulzustands (51, 62, 71, 82) zumindest zweier Batteriemodule (32);
b) Wegschalten einzelner Batteriemodule (32) mit einem niedrigen Batteriemodulzustand (51, 62, 71, 82), wobei der niedrige Batteriemodulzustand (51, 62, 71, 82) durch ein Verhältnis (63, 83) des in Schritt a) ermittelten Batteriemodulzustands (51, 62, 71, 82) zu einem Anfangszustand (61, 81) der Batteriemodule (32) definiert ist,
wobei ein Schwellwert vorgesehen ist und als niedriger Batteriemodulzustand ein Batteriemodulzustand (51, 62, 71, 82) unterhalb des Schwellwerts gilt, **dadurch gekennzeichnet, dass** der Schwellwert nach einer bestimmten Zeit und/oder nach einer bestimmten Anzahl von Lade-/Entladezyklen herabgesetzt wird, wodurch die zu Beginn schwächeren Batteriemodule wieder zugeschaltet werden, wenn der Batteriemodulzustand (51, 62, 71, 82) größer als der Schwellwerts ist.

2. Verfahren nach Anspruch 1, **dadurch gekennzeichnet, dass** eine definierte Anzahl schwächster Batteriemodule (32) weggeschaltet wird.

3. Verfahren nach einem der vorhergehenden Ansprüche, **dadurch gekennzeichnet, dass** Batteriemodule (32) weggeschaltet werden, die zur Bereitstellung einer benötigten Ausgangsspannung nicht benötigt werden.

4. Verfahren nach einem der vorhergehenden Ansprüche, **dadurch gekennzeichnet, dass** der ermittelte Batteriemodulzustand (51, 62) ein SOC ist.

5. Verfahren nach einem der vorhergehenden Ansprüche, **dadurch gekennzeichnet, dass** der ermittelte Batteriemodulzustand (71, 82) ein SOH ist, welcher eine Funktion zweier oder mehrerer Parameter ausgewählt aus der folgenden Liste ist: Widerstand, Kapazität, SOC, Zeit, Lade-/Entladezyklen, Temperatur.

6. Batteriemanagementsystem für eine Batterie, die wenigstens einen Batteriemodulstrang (31) aufweist, wobei der wenigstens eine Batteriemodulstrang (31) eine Mehrzahl in Serie oder parallel geschalteter Batteriemodule (32) umfasst, wobei jedes Batteriemodul (32) eine einzelne oder eine Mehrzahl parallel oder in Serie geschalteter Batteriezellen und eine Koppeleinheit umfasst, welche ausgebildet ist, das Batteriemodul (32) zu- oder wegzuschalten,
mit einer Batteriemodulzustandserfassungseinheit, die ausgebildet ist, einen Batteriemodulzustand (51, 62, 71, 82) der Batteriemodule (32) zu erfassen und
mit einer Steuereinheit, die an die Batteriemodulzustandserfassungseinheit und an mindestens eine Koppeleinheit gekoppelt ist, und die eingerichtet ist, aufgrund eines ermittelten Batteriemodulzustands (51, 62, 71, 82) ein Steuersignal an die Koppeleinheit zu übermitteln, um einzelne Batteriemodule (32) zu- und wegzuschalten,
**dadurch gekennzeichnet, dass** das Batteriemanagementsystem eingerichtet ist, das Verfahren nach einem der Ansprüche 1 bis 5 durchzuführen.

7. Kraftfahrzeug mit einem elektrischen Antriebsmotor zum Antreiben des Kraftfahrzeugs und einer mit dem elektrischen Antriebsmotor verbundenen Batterie (30), die ein Batteriemanagementsystem gemäß Anspruch 6 aufweist.

## Claims

1. Method for battery module balancing of a battery (30), which has at least one battery module string (31), wherein the at least one battery module string (31) comprises a plurality of battery modules (32) connected in series or in parallel, wherein each battery module (32) comprises a single or a plurality of battery cells connected in parallel or in series and a coupling unit, which is designed to connect and disconnect the battery module (32), said method comprising the following steps:
a) determining a battery module state (51, 62, 71, 82) of at least two battery modules (32);
b) disconnecting individual battery modules (32) with a low battery module state (51, 62, 71, 82), wherein the low battery module state (51, 62, 71, 82) is defined by a ratio (63, 83) of the battery module state (51, 62, 71, 82) determined in step a) with respect to an initial state (61, 81) of the battery modules (32),
wherein a threshold value is provided and a battery module state (51, 62, 71, 82) below the threshold value applies as low battery module state, **characterized in that** the threshold value is reduced after a specific time and/or after a specific number of charging/discharging cycles, as a result of which the battery modules which are weaker at the beginning are reconnected if the battery module state (51, 62, 71, 82) is greater than the threshold value.

2. Method according to Claim 1, **characterized in that** a defined number of weakest battery modules (32) is disconnected.

3. Method according to one of the preceding claims, **characterized in that** battery modules (32) which are not required for providing a required output voltage are disconnected.

4. Method according to one of the preceding claims, **characterized in that** the determined battery module state (51, 62) is an SOC.

5. Method according to one of the preceding claims, **characterized in that** the determined battery module state (71, 82) is an SOH, which is a function of two or more parameters selected from the following list: resistance, capacitance, SOC, time, charging/discharging cycles, temperature.

6. Battery management system for a battery, which has at least one battery module string (31), wherein the at least one battery module string (31) comprises a plurality of battery modules (32) connected in series or in parallel, wherein each battery module (32) comprises a single or a plurality of battery cells connected in parallel or in series and a coupling unit, which is designed to connect or disconnect the battery module (32),
comprising a battery module state detection unit, which is designed to detect a battery module state (51, 62, 71, 82) of the battery modules (32), and comprising a control unit, which is coupled to the battery module state detection unit and to at least one coupling unit, and which is designed to transmit a control signal to the coupling unit on the basis of a determined battery module state (51, 62, 71, 82) in order to connect and disconnect individual battery modules (32), **characterized in that** the battery management system is designed to carry out the method according to one of Claims 1 to 5.

7. Motor vehicle comprising an electric drive motor for driving the motor vehicle and a battery (30), which is connected to the electric drive motor and has a battery management system according to Claim 6.

## Revendications

1. Procédé, destiné à équilibrer un module de batterie d'une batterie (30), qui comporte au moins une ligne de modules de batterie (31), l'au moins une ligne de modules de batterie (31) comprenant une pluralité de modules de batterie (32) montés en série ou en parallèle, chaque module de batterie (32) comprenant une seule ou une pluralité de cellules de batterie montées en parallèle ou en série et une unité de couplage, laquelle est conçue pour activer ou désactiver le module de batterie (32), comportant les étapes consistant à :
a) déterminer un état de module de batterie (51, 62, 71, 82) pour au moins deux modules de batterie (32) ;
b) désactiver des modules de batterie (32) individuels présentant un faible état du module de batterie (51, 62, 71, 82), le faible état du module de batterie (51, 62, 71, 82) étant défini par un rapport (63, 83) de l'état du module de batterie (51, 62, 71, 82) déterminé dans l'étape a) dans un état initial (61, 81) du module de batterie (32),
une valeur seuil étant prévue et en tant que faible état de module de batterie étant applicable un état de module de batterie (51, 62, 71, 82) inférieur à la valeur seuil, **caractérisé en ce qu'**on diminue la valeur seuil après un certain temps et/ou après un certain nombre de cycles de chargement/de déchargement, suite à quoi, on réactive les modules de batterie les plus faibles au début, lorsque l'état de module de batterie (51, 62, 71, 82) est supérieur à la valeur seuil.

2. Procédé selon la revendication 1, **caractérisé en ce qu'**on désactive un nombre défini de modules de batterie (32) les plus faibles.

3. Procédé selon l'une quelconque des revendications précédentes, **caractérisé en ce qu'**on désactive des modules de batterie (32) qui ne sont pas nécessaires pour mettre à disposition une tension de sortie nécessaire.

4. Procédé selon l'une quelconque des revendications précédentes, **caractérisé en ce que** l'état de module de batterie (51, 62) déterminé est un SOC.

5. Procédé selon l'une quelconque des revendications précédentes, **caractérisé en ce que** l'état de module de batterie (71, 82) déterminé est un SOH, lequel est une fonction de deux ou de plusieurs paramètres, sélectionnés dans la liste suivante : la résistance, la capacité, le SOC, le temps, les cycles de chargement/de déchargement, la température.

6. Système de gestion de batterie destiné à une batterie qui comprend au moins une ligne de modules de batterie (31), l'au moins une ligne de modules de batterie (31) comprenant une pluralité de modules de batterie (32) montés en série ou en parallèle, chaque module de batterie (32) comprenant une seule ou une pluralité de cellules de batterie montées en parallèle ou en série et une unité de couplage, laquelle est conçue pour activer ou désactiver le module de batterie (32), pourvu d'une unité de détection d'état de module de batterie qui est conçue pour détecter un état de module de batterie (51, 62, 71, 82) des modules de batterie (32) et
pourvu d'une unité de commande, qui est couplée à l'unité de détection d'état de module de batterie et à au moins une unité de couplage et qui est aménagée pour transmettre un signal de commande à l'unité de couplage, sur la base d'un état de module de batterie (51, 62, 71, 82) déterminé, pour activer ou désactiver des modules de batterie (32) individuels,
**caractérisé en ce que** le système de gestion de batterie est aménagé pour réaliser le procédé selon l'une quelconque des revendications 1 à 5.

7. Véhicule automobile, pourvu d'un moteur d'entraînement électrique, destiné à entraîner le véhicule automobile et d'une batterie (30) connectée au moteur d'entraînement électrique, qui comporte un système de gestion de batterie selon la revendication 6.
